# EUROPEAN PATENT APPLICATION

(11) **EP 2 931 010 A1**
(43) Date of publication of application: **14.10.2015**
(21) Application number: 13860808.8
(22) Date of filing: 06.12.2013
(51) Int. Cl.: H05K 1/18, H05K 3/32, H05K 3/46

(54) **PRINTED CIRCUIT BOARD**

(30) Priority: 07.12.2012 KR 20120141577
(71) Applicant: Tyco Electronics AMP Korea Ltd., Gyeongsangbuk-do 712-837 (KR)
(72) Inventor: CHOI, Yang Yoon, Gyeongsangbuk-do 712-837 (KR); BEAK, Ok Ky, Siheung-si Gyeonggi-do 429-854 (KR)
(74) Representative: Johnstone, Douglas Ian
(86) International application number: PCT/KR2013/011249
(87) International publication number: WO 2014/088358

(57) **Abstract**

Disclosed is a printed circuit board which can prevent the occurrence of damage to a component insertion hole or a broken electrical connection due to an impact during component insertion when components are mounted on the printed circuit board or any impact which occurs after component mounting. The printed circuit board comprises: a substrate having a circuit pattern formed thereon; a main hole which is formed so as for a component to be mounted on the substrate; and one or more secondary holes formed around the main hole, wherein the main hole and the secondary hole(s) may have the same electrical configuration.

## Description

### Technical Field

The present invention relates to a printed circuit board (PCB) that may enable stable electrical conduction in a component insertion hole despite damage occurring to the component insertion hole or the PCB when mounting a component on the PCB.

### Background Art

In general, a printed circuit board (PCB) is a component in which electric wirings are integrated to allow various devices to be populated therein or to be electrically connected to one another. A technological development has been promoting production of PCBs having various forms and functions. A demand for such PCBs has been increasing with a growth of industries using the PCBs and relating to, for example, home appliances, communication devices, semiconductor equipment, industrial machinery, and electrical control of a vehicle. In addition, PCB products are being transformed into a miniaturized, light-weighted, and high value-added products as electronic components become smaller and more sophisticated.

A predominant feature of such electronic components may be discovered in that various added complex functions consume a considerable amount of power and generate a greater amount of heat. Thus, a degree of heat generated from an electronic product may be a factor used to evaluate a degree of satisfaction with the electronic product and a standard of purchasing.

An existing PCB includes a hole for mounting electronic components. A component insertion hole may be damaged due to an impact occurring when an electronic component is inserted into the component insertion hole or an impact occurring after an electronic component is mounted. In addition, such an impact may disconnect an electrical connection between the electronic components and the PCB.

Further, a solderless method is used for the PCB in lieu of an existing soldering method due to environmental regulations. Such a solderless method may include fixing a terminal or a pin to a hole formed on the PCB using a dimensional tolerance, in an interference fit manner. The interference fit may allow a surface of the terminal to be fixed and electrically conductive while making scratches on a plated layer of an inner side of the hole. When inserting the terminal, a partial or entire plating of the inner side of the hole may be broken due to a dimension of the terminal and a tolerance for the hole, or due to poor plating on the inner side. Thus, an electrical disconnection may occur between layers of the PCB.

### Disclosure of Invention

### Technical Goals

To handle such issues described in the foregoing, an aspect of the present invention provides a printed circuit board (PCB) that may prevent an electrical disconnection of the PCB despite damage occurring in a component insertion hole due to an impact occurring at a time of inserting a component when mounting the component on the PCB or an impact occurring after mounting the component on the PCB.

### Technical Solutions

According to an aspect of the present invention, there is provided a printed circuit board (PCB) including a substrate on which a circuit pattern is formed, a main hole formed to allow a component to be mounted on the substrate, and at least one secondary hole formed around the main hole. The main hole and the secondary hole may have identical electrical configurations on a single circuit pattern.

The secondary hole may be formed to have a cross-sectional area smaller than or equal to a cross-sectional area of the main hole. The main hole may have a cross-sectional form of any one of a circular form, an elliptical form, and a polygonal form. The secondary hole may have a cross-sectional form of any one of a circular form, an elliptical form, and a polygonal form.

The main hole and the secondary hole may be formed to penetrate the substrate, and interiors of the main hole and the secondary hole may have identical electrical configurations. The main hole and the secondary hole may be formed by drilling or laser processing.

The substrate may include a core layer, a base layer formed of an aluminum material and bonded on both sides of the core layer, a bonding member interposed to bond the base layer to the core layer, the main hole and the secondary hole formed to penetrate the core layer, the bonding member, and the base layer, and a substitution layer formed by performing surface treatment to zincify a surface of the base layer and a portion exposed to an inner side of the main hole and the secondary hole, a plating layer formed on the substitution layer, and a circuit pattern formed on the plating layer. For example, the core layer may be formed of a metallic material including aluminum or copper. Also, the core layer may be formed of an insulating material. The PCB may further include a metal layer to metalize a portion of a layer of an insulating material exposed to the inner side of the main hole and the secondary hole. The substitution layer may be formed on a remaining portion exposed to the inner side of the main hole and the secondary hole, from which the metal layer is excluded. The plating layer may be formed to cover both the substitution layer and the metal layer. The substitution layer may be formed to have a thickness equal to a thickness of the metal layer. The plating layer may include a first plating layer formed on a surface of the substitution layer through electrolytic or electroless plating, and a second plating layer of a cupric material formed on the first plating layer through the electrolytic plating. The first plating layer may be formed on the substitution layer apart from the metal layer, or formed to cover a portion of the metal layer. The second plating layer may be formed to cover a portion of the metal layer on which the first plating layer is not formed.

The substrate may include a core layer, a base layer formed of an aluminum material and bonded on both sides of the core layer, and a bonding member interposed to bond the base layer to the core layer. A layered substrate may be formed by layering the core layer, the base layer, and the bonding member at least twice. The main hole and the secondary hole may be formed to penetrate the layered substrate. The PCB may further include a substitution layer formed by performing surface treatment to zincify a surface of the base layer formed in an outermost portion of the layered substrate and a portion exposed to an inner side of the main hole and the secondary hole, a plating layer formed on the substitution layer, and a circuit pattern formed on the plating layer. In addition, the PCB may further include a metal layer to metalize a portion of a layer of an insulating material exposed to the inner side of the main hole and the secondary hole. The substitution layer may be formed on a remaining portion exposed to the inner side of the main hole and the secondary hole, from which the metal layer is excluded.

### Effects of Invention

As described in the foregoing, damage occurring in a component insertion hole due to an impact occurring at a time of inserting a component when mounting the component on a printed circuit board (PCB) or an impact occurring after mounting the component on the PCB, or an electrical disconnection may be prevented.

### Brief Description of Drawings

FIG 1 is a cross-sectional view of a printed circuit board (PCB) in which a secondary hole is formed according to an embodiment of the present invention.
FIG. 2 is a cross-sectional view of a PCB according to another embodiment of the present invention.
FIG. 3 is a cross-sectional view of a main hole and a secondary hole of the PCB of FIG 1.
FIG. 4 is a planar view of a state in which a terminal or a pin is inserted in a main hole of the PCB of FIG 1.
FIG 5 is a planar view of a state in which the terminal or the pin of FIG 4 is inserted in a main hole.
FIG 6 is a planar view of a main hole and a secondary hole according to another embodiment of the present invention.

### Best Mode for Carrying Out Invention

Reference will now be made in detail to embodiments of the present invention, examples of which are illustrated in the accompanying drawings, wherein like reference numerals refer to the like elements throughout. The embodiments are described below in order to explain the present invention by referring to the figures. In descriptions of illustrative examples provided herein, known functions or configurations may be omitted to clearly deliver a point of the present invention.

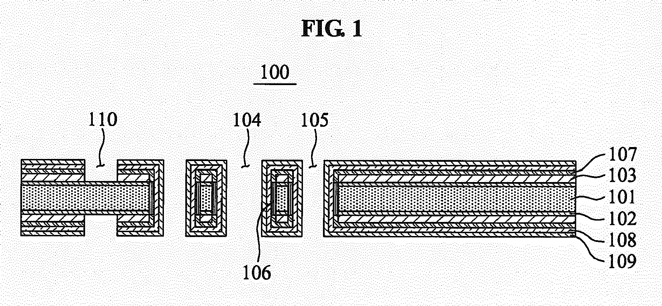

Hereinafter, a printed circuit board (PCB) on which a secondary hole is formed will be described in detail with reference to FIGS. 1 through 6. Unless indicated otherwise, a phrase "on a layer" may refer to "on both an upper face and a lower face of a layer."

Referring to FIG 1, a PCB 100 includes a main hole 104 into which a component is inserted to be mounted on the PCB 100, and at least one secondary hole 105 formed around the main hole 104 to form a single pattern.

Hereinafter, a method of manufacturing the PCB 100 including the secondary hole 105 will be described. The PCB 100 includes a base layer 103 of an aluminum material bonded on both faces of a core layer 101 using a bonding member 102. Here, a general copper-based PCB may be used as the PCB 100. Alternatively, a PCB of an aluminum material in lieu of a copper substrate may be used as the PCB 100. For example, a metallic material including aluminum or an insulating material may be used for the core layer 101. In addition, a polyimide-based insulating bonding sheet which is an adhesive having a desirable adhesion and an insulating function to bond the base layer 103 of aluminum, or an epoxy-based adhesive such as a glass epoxy resin may be used as the bonding member 102.

A metal layer 106 is formed to metalize an insulting material portion exposed to an inner side of the main hole 104 and the secondary hole 105. For example, the metal layer 106 may form a carbon plating layer using a carbon direct plating method. With the formation of the metal layer 106, the base layer 103 formed on and below the core layer 101 is electrically connected.

In detail, in a case of the core layer 101 of the insulating material, the metal layer 106 is formed on all portions of the core layer 101 and the bonding member 102 exposed to the inner side of the main hole 104 and the secondary hole 105. In a case of the core layer 101 of the metallic material, the metal layer 106 is formed on a portion of the bonding member 102 of the insulting material, which is exposed to the inner side of the main hole 104 and the secondary hole 105.

A substitution layer 107 is formed by substituting a zinc film for a portion of a surface of the base layer 103 based on a thickness of the metal layer 106. The substitution layer 107 is not formed on the metal layer 106, and formed identically in the main hole 104 and the secondary hole 105. With the formation of the substitution layer 107, aluminum may be prevented from being oxidized in an atmosphere to protect the surface of the base layer 103. In addition, corrosion of the surface of the base layer 103 may be prevented in a process of electrolytic plating and electroless plating to be subsequently performed.

A first plating layer 108 is formed through the electrolytic and the electroless plating performed on the substitution layer 107. Similarly, the first plating layer 108 is formed identically in the main hole 104 and the secondary hole 105. The first plating layer 108 is formed by performing displacement plating on the substitution layer 107 using a metal film having a strong chemical resistance. For example, the first plating layer 108 is formed by performing the displacement plating using nickel (Ni) to substitute a nickel film for the substitution layer 107. However, the displacement plating is not limited to using nickel, and other metals having a strong chemical resistance, for example, gold (Au) and silver (Ag), may be used for the displacement plating. The first plating layer 108 is formed to cover a surface of the substitution layer 107, and also cover a portion or an entirety of the metal layer 106. Alternatively, the first plating layer 108 is formed only on the substitution layer 107 apart from the metal layer 106. A second plating layer 109 is formed on the first plating layer 108 using electro-copper plating, and formed identically in the main hole 104 and the secondary hole 105. To form a predetermined circuit pattern 110 on the second plating layer 109, a dry film is applied onto a surface of the second plating layer 109, and exposure and development are performed for a predetermined amount of time. Subsequent to the formation of the pattern, the second plating layer 109, the first plating layer 108, the substitution layer 107, and the base layer 103 are removed along the pattern of the dry film to form the PCB 100 in which the circuit pattern 110 is formed. The circuit pattern 110 is formed using hydrochloric acid-based acidic etching based on the pattern of the dry film. For example, a hydrochloric acid type may include ferric chloride, cupric chloride, and sodium chlorate.

Here, a surface of the metal layer 106 is covered by at least one of the first plating layer 108 and the second plating layer 109. In detail, when the first plating layer 108 does not cover the metal layer 106, the second plating layer 109 is formed to cover the surface of the metal layer 106. When the first plating layer 108 covers a portion of the metal layer 106, the second plating layer 109 covers the first plating layer 108 and a portion of the metal layer 106 that is not covered by the first plating layer 108. When the first plating layer 108 fully covers the metal layer 106, the two layers, the first plating layer 108 and the second plating layer 109, are formed on the metal layer 106.

According to an embodiment, since the metal layer 106, the substitution layer 107, the first plating layer 108, and the second plating layer 109 are formed identically in the main hole 104 and the secondary hole 105, interiors of the main hole 104 and the secondary hole 105 may have identical electrical configurations. Here, the term "electrical configurations" may indicate identical forming orders or shapes of the metal layer 106, the substitution layer 107, the first plating layer 108, and the second plating layer 109.

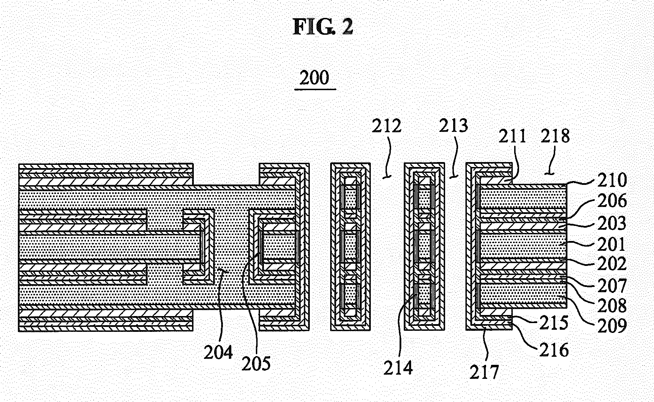

Although a double-sided PCB is illustrated as the PCB 100, the PCB 100 is not limited to the double-sided PCB. The illustrative examples described in the foregoing may be identically applied to a multilayer PCB 200, which is formed by layering at least two double-sided PCBs, to be described hereinafter. For example, as illustrated in FIG 2, the multilayer PCB 200 may be used. Descriptions of the multilayer PCB 200 may be substantially identical to the descriptions of the double-sided PCB provided in the foregoing. Thus, components of the multilayer PCB 200 identical to the components of the PCB 100 described with reference to FIG. 1 will be referred to using the same names of the components of the PCB 100, and repeated descriptions will be omitted here for brevity.

Referring to FIG 2, the multilayer PCB 200 includes an insulation layer 209 of an insulating material to fill a circuit pattern on a PCB including components, for example, 201 through 208, formed as described with reference to FIG. 1. A general-type copper-based substrate or an aluminum-based substrate may be used for the multilayer PCB 200. Alternatively, a metallic material including aluminum or an insulating material may be used for a core layer 201 of the multilayer PCB 200.

The insulation layer 209 is formed to fill both the circuit pattern and a via hole 204. A base layer 211 of an aluminum material is formed on and below the insulation layer 209. For example, an aluminum foil having a predetermined thickness may be used for the base layer 211. The base layer 211 and the insulation layer 209 are bonded together using a bonding member 210 such as a polyimide-based insulating bonding sheet and an epoxy-based adhesive.

Subsequent to the formation of the insulation layer 209, the bonding member 210, and the base layer 211, a main hole 212 and a secondary hole 213 are formed to penetrate the PCB including the components 201 through 208, the insulation layer 209, the bonding member 210, and the base layer 211.

Subsequently, a metal layer 214, a substitution layer 215, a first plating layer 216, a second plating layer 217 are sequentially formed in the main hole 212 and the secondary hole 213 to form a predetermined circuit pattern 218 using a dry film and to form the multilayer PCB 200. Here, operations of forming the metal layer 214, the substitution layer 215, the first plating layer 216, and the second plating layer 217 in the main hole 212 and the secondary hole 213 are identical to the operations described with reference to FIG. 1 and thus, repeated descriptions will be omitted here for brevity.

Although a double-layered PCB is illustrated as the multilayer PCB 200, the multilayer PCB 200 is not limited to the double-layered PCB. A higher-layered PCB including at least three layers may also be applicable as the multilayer PCB 200. The present invention may not be limited to the configuration of the PCB 100 described with reference to FIG. 1 and thus, various modifications may be made to the configurations of the PCB 100.

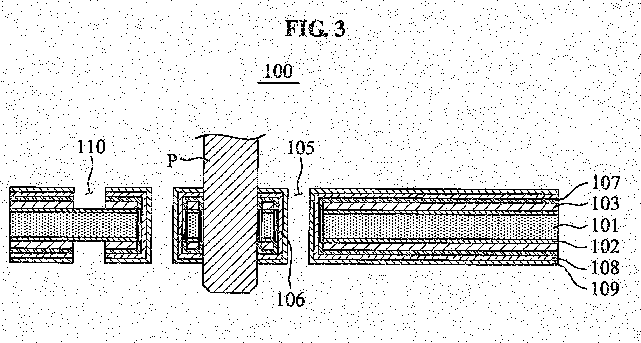

Hereinafter, the main hole 104 and the secondary hole 105 will be further described with reference to FIGS. 3 through 6. For ease of description, descriptions to be provided hereinafter are applied to the configurations of the PCB 100 illustrated in FIG. 1. However, the present invention may not be limited thereto, and the descriptions to be provided hereinafter may also be applied to the multilayer PCB 200 illustrated in FIG 2.

The main hole 104 is formed to penetrate the PCB 100 to allow a component to be mounted on the PCB 100. However, the present invention may not be limited thereto, and the main hole 104 may not completely penetrate the PCB 100 and be formed on a surface of the PCB 100 by a predetermined depth.

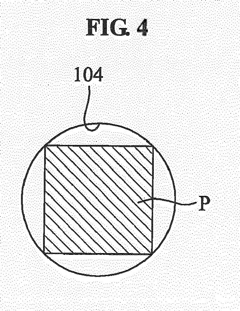

Referring to FIGS. 3 and 4, in a case of a solderless type PCB, a terminal or a pin (P) is fixed to the main hole 104 in a manner of interference fit. During insertion of the terminal or the pin in the main hole 104, the terminal or the pin may be fixed and electrically conductive while making a scratch on a plating layer of an inner side of the main hole 104. Here, a portion or an entirety of the layers formed in the main hole 104 may be broken during the insertion of the terminal or the pin. According to an embodiment, an electrical disconnection between the layers that may occur during the insertion of the terminal or the pin may be prevented by forming the secondary hole 105.

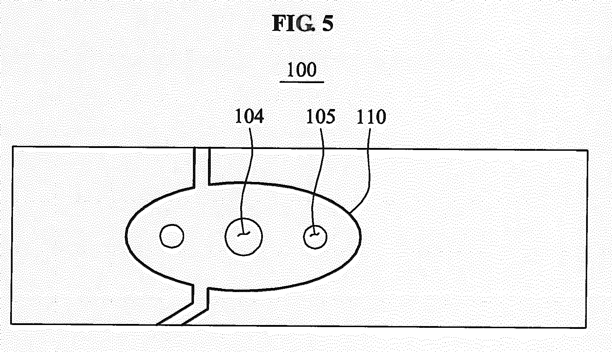

The secondary hole 105 is formed around the main hole 104. Here, a single secondary hole or a plurality of secondary holes may be formed separately from the main hole 104 by a predetermined distance. In addition, when the main hole 104 is damaged due to an impact occurring at a time of inserting a component or an impact occurring after mounting the component, the secondary hole 105 may prevent an electrical disconnection of a circuit and substitute for an electrical configuration of the main hole 104. In detail, referring to FIG. 5, the main hole 104 and the secondary hole 105 are formed on the single circuit pattern 110 to have identical electrical characteristics. Here, the term "identical electrical configurations" may indicate that orders and shapes of forming the layers may be identical both in the main hole 104 and the secondary hole 105. Further, the main hole 104 and the secondary hole 105 are disposed on a single pattern of the circuit pattern 110, and dispositions of conductive layers and insulating layers are identical in the main hole 104 and the secondary hole 105. This is because the dispositions of the layers in the main hole 104 may form a circuit and thus, the secondary hole 105 may allow a normal electrical operation to be performed in place of the main hole 104 when the main hole 104 is damaged.

The main hole 104 and the secondary hole 105 are formed by performing drilling or laser processing on the PCB 100. Although cross-sectional forms of the main hole 104 and the secondary hole 105 are illustrated as a circular form, the forms may not be limited to the illustrated form. The cross-sectional forms of the main hole 104 and the secondary hole 105 may be various, for example, an elliptical or polygonal form. In addition, although the secondary hole 105 is illustrated to be smaller than the main hole 104, the sizes of the main hole 104 and the secondary hole 105 may not be limited to the illustrative example, and cross-sectional areas of the main hole 104 and the secondary hole 105 may be equal to each other.

Further, although two secondary holes are illustrated as the secondary hole 105, the number of the secondary hole 105 may not be limited thereto, and the number and a position of the secondary hole 105 may vary.

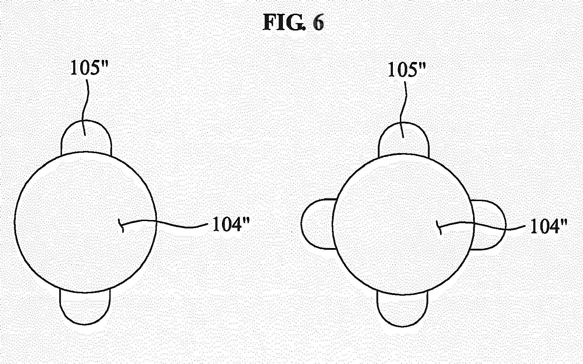

For example, the main hole 104 and the secondary hole 105 may not be separate from each other, and may be connected. Referring to FIG. 6, a secondary hole 105' and a secondary hole 105" are formed around a main hole 104' and a main hole 104" to be connected to the main hole 104' and the main hole 104". A plurality of the secondary holes 105' and 105" may be disposed at equidistant intervals or irregular intervals.

With the main holes 104' and 104" and the secondary holes 105' and 105" formed to be connected to one other, the secondary holes 105' and 105" may substitute for electrical characteristics of the main holes 104' and 104". Such a formation may function as a heat sink to allow heat to readily radiate through the main holes 104' and 104" and the secondary holes 105' and 105".

Although a single main hole is illustrated to be connected to a plurality of secondary holes, the present invention may not be limited to such a form, and a plurality of main holes may be connected to a plurality of secondary holes. In addition, sizes and forms of the main hole 104 and the secondary hole 105 may be variously modified.

A PCB manufactured in accordance with example embodiments described herein may be applicable to an electronic component for a vehicle.

According to example embodiments, when damage to a component insertion hole or an electrical disconnection occurs due to an impact occurring at a time of inserting a component to be mounted on the PCB 100 or after mounting the component on the PCB 100, the secondary hole 105 may substitute for the main hole 104 to prevent occurrence of damage and faultiness. In addition, since the secondary hole 105 is formed around the main hole 104, heat generated from an electronic component inserted in the main hole 104 may be effectively released.

While this disclosure includes specific examples, it will be apparent to one of ordinary skill in the art that various changes in form and details may be made in these examples without departing from the spirit and scope of the claims and their equivalents. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner and/or replaced or supplemented by other components or their equivalents.

Therefore, the scope of the disclosure is defined not by the detailed description, but by the claims and their equivalents, and all variations within the scope of the claims and their equivalents are to be construed as being included in the disclosure.

## Claims

1. A printed circuit board (PCB), comprising:
a substrate on which a circuit pattern is formed;
a main hole formed to allow a component to be mounted on the substrate; and
at least one secondary hole formed around the main hole, and
wherein the main hole and the secondary hole have identical electrical configurations on a single circuit pattern.

2. The PCB of claim 1, wherein the secondary hole is formed to have a cross-sectional area smaller than or equal to a cross-sectional area of the main hole.

3. The PCB of claim 1, wherein the main hole has a cross-sectional form of any one of a circular form, an elliptical form, and a polygonal form.

4. The PCB of claim 1, wherein the secondary hole has a cross-sectional form of any one of a circular form, an elliptical form, and a polygonal form.

5. The PCB of claim 1, wherein the main hole and the secondary hole are formed to penetrate the substrate, and interiors of the main hole and the secondary hole have identical electrical configurations.

6. The PCB of claim 5, wherein the main hole and the secondary hole are formed by drilling or laser processing.

7. The PCB of claim 1, wherein the substrate comprises:
a core layer;
a base layer formed of an aluminum material and bonded on both sides of the core layer;
a bonding member interposed to bond the base layer to the core layer;
the main hole and the secondary hole formed to penetrate the core layer, the bonding member, and the base layer;
a substitution layer formed by performing surface treatment to zincify a surface of the base layer and a portion exposed to an inner side of the main hole and the secondary hole;
a plating layer formed on the substitution layer; and
a circuit pattern formed on the plating layer.

8. The PCB of claim 7, wherein the core layer is formed of a metallic material comprising aluminum or copper.

9. The PCB of claim 7, wherein the core layer is formed of an insulating material.

10. The PCB of claim 7, further comprising:
a metal layer to metalize a portion of a layer of an insulating material exposed to the inner side of the main hole and the secondary hole, and
wherein the substitution layer is formed on a remaining portion exposed to the inner side of the main hole and the secondary hole, from which the metal layer is excluded, and
the plating layer is formed to cover both the substitution layer and the metal layer.

11. The PCB of claim 10, wherein the substitution layer is formed to have a thickness equal to a thickness of the metal layer.

12. The PCB of claim 10, wherein the plating layer comprises a first plating layer formed on a surface of the substitution layer through electrolytic or electroless plating, and a second plating layer of a cupric material formed on the first plating layer through the electrolytic plating.

13. The PCB of claim 12, wherein the first plating layer is formed on the substitution layer apart from the metal layer, or formed to cover a portion of the metal layer, and
the second plating layer is formed to cover a portion of the metal layer on which the first plating layer is not formed.

14. The PCB of claim 1, wherein the substrate comprises:
a core layer;
a base layer formed of an aluminum material and bonded on both sides of the core layer; and
a bonding member interposed to bond the base layer to the core layer; and
wherein a layered substrate is formed by layering the core layer, the base layer, and the bonding member at least twice, and
the main hole and the secondary hole are formed to penetrate the layered substrate.

15. The PCB of claim 14, further comprising:
a substitution layer formed by performing surface treatment to zincify a surface of the base layer formed in an outermost portion of the layered substrate and a portion exposed to an inner side of the main hole and the secondary hole;
a plating layer formed on the substitution layer; and
a circuit pattern formed on the plating layer.

16. The PCB of claim 15, further comprising:
a metal layer to metalize a portion of a layer of an insulating material exposed to the inner side of the main hole and the secondary hole, and
wherein the substitution layer is formed on a remaining portion exposed to the inner side of the main hole and the secondary hole, from which the metal layer is excluded.
